# EUROPÄISCHE PATENTSCHRIFT

(11) **EP 0 443 155 B1**
(45) Veröffentlichungstag und Bekanntmachung des Hinweises auf die Patenterteilung: **25.01.1995**
(21) Anmeldenummer: 90124484.8
(22) Anmeldetag: 18.12.1990
(51) Int. Cl.: H02M 3/335

(54) **Schaltgerät zur Ein- und Ausschaltung**
Switchgear for switch-on and switch-off
Appareillage électrique pour enclencher et déclencher

(30) Priorität: 17.02.1990 DE 4005168
(43) Veröffentlichungstag der Anmeldung: 28.08.1991
(73) Patentinhaber: Jungheinrich Aktiengesellschaft, 22047 Hamburg (DE)
(72) Erfinder: Maasland, Hans-Hermann, Ing. grad., W-2359 Henstedt-Ulzburg 1 (DE)
(74) Vertreter: Patentanwälte Hauck, Graalfs, Wehnert, Döring, Siemons

(56) Entgegenhaltungen:
- US-A- 4 695 935
- US-A- 4 727 464
- US-A- 4 809 148
- US-A- 4 864 479

## Beschreibung

Die Erfindung betrifft ein Schaltgerät zur Ein- und Ausschaltung mit hoher Schaltfrequenz zwecks Wechselrichtung einer elektrischen Größe, in Verbindung mit einem Transformator oder Motor, bestehend aus Leistungshalbleitern mit einem Treiber zur Schaltung der parallel geschalteten Halbleiter.

Eine elektrische Größe sind Spannung oder Strom.

Der über den galvanisch trennenden Transformator fließende Strom wird anschließend gleichgerichtet.

Solche Geräte sind in der bevorzugten Anwendung Lade- und Schweißgeräte. Hierbei sind Sperrwandler- oder Durchflußwandler-Varianten bekannt. Beispielsweise sind aus der Grundlagen-Literatur "Halbleiter-Schaltungstechnik" (Springer-Verlag) und "Schaltnetzteil-Steuerschaltung" (Siemens) Durchflußvarianten bekannt.

Der Einsatz kann unter anderem in Eintakt-, Gegentakt-, Halbbrücken-und Vollbrücken-Durchflußwandlern erfolgen.

Bei einem bekannten asymmetrischen Halbbrücken-Durchflußwandler sind bereits zwei Halbleiter einem zwei Wicklungen aufweisenden Wandler vorgeschaltet, wobei jedoch hier eine Zusammenschaltung derart vorgesehen ist, daß jedem Anschluß der Primärwicklung ein Halbleiter vorgeschaltet ist, der dann mit einem Anschluß mit einem anderen Halbleiter über eine Diode zur Entmagnetisierung des Transformatorkerns verbunden ist. Diese Ausführung hat schon gewisse Vorteile hinsichtlich der unproblematischen Ausschaltzeit der Leistungstransistoren, aber auch den Nachteil eines doppelten Übergangswiderstandes. Insofern arbeitet diese bekannte Ausführung nicht befriedigend.

Zur Verringerung der Verlustleistung pro Zweig werden MOS-FET Leistungshalbleiter parallel geschaltet.

Es werden im übrigen dann auch bei dem Einsatz gleicher Leistungshalbleiter gleichmäßige Charakteristika erzeugt.

Aus Gründen minimaler Verlustleistung wird angestrebt, bei Stromrichtern, zum Beispiel für Ladegeräte für Batterien, hohe Frequenzen einzusetzen. Ein Stromrichter der eingangs genannten Art ist aus der FR-A-2 615 154 bekanntgeworden. Er weist eine Parallelschaltung aus einem steuerbaren Leistungshalbleiter und einem MOSFET auf, und beide Halbleiter sind so angesteuert, daß der MOSFET gegenüber dem anderen Halbleiter zeitlich verzögert sperrt. Da der andere Halbleiter ein bipolarer Transistor ist, dient der MOSFET dazu, die Schaltung des bipolaren Transistors zu erleichtern.

Der MOSFET wird jeweils nur kurzzeitig eingeschaltet, wobei die Ansteuerung des MOSFET über eine separate Treiberschaltung erfolgt. Die Ansteuerung des bipolaren Transistors erfolgt durch einen das Vorzeichen wechselnden Steuerstrom, der beim Ausschalten eine Entsättigung herbeiführt. Ein Strom fließt durch den MOSFET erst dann, wenn der Entsättigungsstrom die Entsättigung des bipolaren Transistors bewirkt und der Strom kleiner zu werden beginnt. Die Sperrspannung des MOSFET wird wieder aufgebaut, sobald die Gate-Source-Spannung verringert wird in Abhängigkeit von der Drain-Source-Spannung. Nachteilig bei der bekannten Schaltung ist daher die zusätzliche Treiberschaltung, wobei der Aufwand insbesondere bei höheren Frequenzen beträchtlich ist.

Aus der US-A-4 809 148 ist bekanntgeworden, zwei MOSFETS parallel anzuordnen und über eine einzige Treiberschaltung zu betreiben. Dadurch können sehr hohe Frequenzen verwendet werden, wobei dann jedoch bei hoher Spannungsfestigkeit eine hohe Durchlaß-Verlustleistung hingenommen werden muß.

Der Erfindung liegt die Aufgabe zugrunde, einen Stromrichter für höhere Frequenzen, insbesondere über 20.000 Hz, zu schaffen, dessen Steuerung mit geringem Aufwand betrieben werden kann und dessen Durchlaß- und Ausschalt-Verlustleistungen minimal sind.

Diese Aufgabe wird erfindungsgemäß gelöst durch die Merkmale des Patentanspruchs 1.

Mit besonderem Vorteil sind als Leistungshalbleiter MOS-FET-Halbleiter und IGBT-Leistungshalbleiter vorgesehen, und dabei ist der MOS-FET-Halbleiter weitgehend frequenzunabhängig. Diese Leistungshalbleiter arbeiten über einen beträchtlichen Spannungsbereich, wobei ferner der IGBT-Leistungshalbleiter in höherem Frequenzbereich arbeitet.

Vorteilhaft wird einbezogen, daß Leistungshalbleiter vorgesehen sind, die für verschieden bemessene Frequenzbereiche ausgeführt sind. Unter dem vorteilhaften Merkmal, daß der MOS-FET-Halbleiter weitgehend frequenzunabhängig ist und über einen beträchtlichen Spannungsbereich der IGBT-Leistungshalbleiter im höheren Spannungsbereich und in höherem Frequenzbereich arbeiten, kann für den MOS-FET-Leistungshalbleiter davon ausgegangen werden, daß der Strom vor einem Sperrspannungsanstieg sehr schnell abgeschaltet werden kann, wodurch die Ausschaltverlustleistung gering ist. Hierbei wird ein relativ hoher Spannungsabfall am MOS-FET-Leistungshalbleiter zu dem Zweck einer kurzzeitigen Pulsbelastung ausgenutzt, die jedoch wesentlich geringer ist als die Ausschaltverluste des IGBT.

In der Ausführungsform arbeitet dabei der IGBT-Halbleiter bei höheren Frequenzen mit geringerer Ausschaltverlustleistung und der MOS-FET-Leistungshalbleiter mit geringeren Durchlaßverlusten, wobei eine Parallelschaltung mit der Treiber-Ausführung eine optimale Aufteilung hinsichtlich des durch die Parallelschaltung durchgelassenen Stroms mit geringer Verlustleistung beim Ein- und Ausschalten ergibt. Diese Ausführung stellt eine besonders günstige Ausgestaltung des Schaltgerätes dar, wobei insbesondere dadurch auch der Zusammenhang zwischen den verschiedenen Halbleitern in optimaler Weise ausgenutzt wird.

Dabei liegt ein vorteilhaftes Merkmale darin, daß bei der Ausschaltung die Gate/Sourcespannung am MOS-FET-Leistungshalbleiter durch den Entladestrom über im Treiber zugeordneten Widerstand im Treiber so stark verzögert wird, daß der Strom vorwiegend über einen definierten Zeitbereich (z. B. t = 200 ns) vom IGBT-Leistungshalbleiter auf den MOS-FET-Leistungshalbleiter übergeht und den IGBT entsättigt.

Weiterhin weist der MOS-FET-Halbleiter einen relativ hohen Durchlaßwiderstand (Rds on) bei hoher Spannungsfestigkeit und somit hohe Durchlaßverlustleistung, aber geringe Schaltverluste auf, und der IGBT-Leistungshalbleiter besitzt bei geringen Durchlaßverlusten hohe Schaltverluste, aber in der Parallelschaltung sind bei reduzierten Durchlaßverlusten auch geringe Schaltverluste erreichbar. Dadurch wird die wechselseitige Kompensation zum Ausdruck gebracht.

Diese hohe Durchlaßverlustleistung ist ein Gesichtspunkt. Zu diesem gehört weiterhin aber, daß ein IGBT-Leistungshalbleiter eine sehr schnelle Stromabschaltung bis auf ca. 20 % Reststrom im ns-Bereich hat. Ein sich anschließender Stromschwanz im »s-Bereich bewirkt mit dem Sperrspannungsanstieg, der sehr früh seinen maximalen Wert erreicht, erhöhte Ausschaltverlustleistung.

Bevorzugt wird ein Einsatz in einem Frequenzbereich über 20 kHz an Stelle von 10 bis 20 kHz, und zwar unter Einsatz der IGBT mit wesentlich kleineren Halbleiterchips und damit in ca. 50 % kostengünstigerer Lösung als eine reine MOS-FET-Version.

Grundsätzlich kann davon ausgegangen werden, daß die Bauelemente bei höheren Frequenzen mit dem Ziel der Verminderung der Stromverlustleistung beim Abschalten einsetzbar sind bzw. die anderen Elemente bei höheren Durchlaßströmen unter Verminderung der Durchlaßverlustleistung. In einer bevorzugten Ausführungsform ist bei einem Schaltelement, dem IGBT, im Fall der Einschaltung der Gate/Sourcespannungsanstieg gering verzögert, um die Einschalt-Verlustleistung auf den MOS-FET zu übergeben, wobei der Stromanstieg im IGBT leicht verzögert ist und der Vorwiderstand im Treiber ca. in der gleichen Größenordnung sein kann aufgrund der unterschiedlichen Eingangskapazitäten von IGBT und MOS-FET.

Dabei kann die Gate/Sourcespannung am MOS-FET so eingestellt sein, daß die Stromaufteilung durch die feste Durchlaßspannung am IGBT (z. B. Uds = 3,5 V) sich grundsätzlich auf einen wesentlich geringeren konstanten Wert des halben Gesamtnennstroms (z. B. von Idsg = 20 A; IGBT ca. 18 A; IFET ca. 2 A) einstellt.

Auch bei dem oben angegebenen Zeitbereich für den Stromübergang wird kurzzeitig ein Pulsstrom erreicht, um den IGBT-Halbleiter zu entlasten. Die Spannung steigt auf die MOS-FET-Durchlaßspannung an, anschließend um die eingestellte Zeit, verzögert auf die Sperrspannung.

In der bevorzugten Ausführungsform wird der weitere Vorteil in Anspruch genommen, daß der IGBT-Stromschwanz bei voller Sperrspannung statt 100 % (z. B. ca. t = 800 bis 1000 ns) nur noch ca. 20 % (z. B. t = 200 ns) ausmacht.

Die Entsättigung des internen Bipolar-Transistors im IGBT wird durch den MOS-FET beschleunigt. Die Ausschalt-Verlustleistung im IGBT reduziert sich ca. um den Faktor "5" (auf ca. 20 %), welches eine höhere Betriebsfrequenz ermöglicht.

Unter einem weiteren vorteilhaften Gesichtspunkt sind Steuerelektroden der Leistungshalbleiter über verschieden bemessene Vorwiderstände des Treibers angeschlossen. Hierbei bewirkt die Parallelschaltung der verschiedenen Bauelemente eine präzise Ansteuerung der Gate/Sourcespannung bezüglich des Zeit- und Spannungsverhaltens, um die Stromaufteilung und das Ein-Ausschaltverhalten gezielt zu optimieren.

In einer bevorzugten Ausführung der Erfindung ist im Bereich der Abschaltung im Treiber eine Vorspannung herstellbar, welche in Verbindung mit den Kapazitäten der jeweiligen Halbleiter im Bereich der Steuerelektroden einen verschiedenen Ausschaltzeitpunkt an den beiden Leistungshalbleitern herbeiführt. Hierin liegt eine besonders vorteilhafte Ausgestaltung, weil ein Treiber beliebig ausgeführt und in Anpassung eingesetzt werden kann.

Gemäß obigen Darlegungen gehen die verschiedenen Ausgestaltungen auch auf jeweils besondere Merkmale in dem sogenannten Treiber zurück, welcher eine Anschlußsteuerschaltung darstellt.

Der Einsatz auch der verschiedenen kapazitiven Kenngrößen der Halbleiter in Verbindung mit im Treiber angeordneten verschiedenen Vorwiderständen schafft eine Voraussetzung dafür, daß insbesondere verschiedene Ausschaltzeitpunkte erreicht werden. Durch solche wird dann der Strom in der Parallelschaltung von dem einen zu dem anderen Element übergeleitet, und dadurch werden optimale Bedingungen hinsichtlich der Durchgangs-und Ausschaltverluste erzielt.

Bevorzugt wird, daß jeweils ein IGBT- und ein MOS-FET-Halbleiter parallel geschaltet sind.

Dabei liegt eine besonderer Vorteil darin, daß Leistungshalbleiter mit verschiedenen Abschaltgeschwindigkeiten und Ausschaltverlustleistungen, jedoch umgekehrt mit relativ verschieden hohen Durchlaßwiderständen vorgesehen sind. Zu berücksichtigen ist dabei, daß die Durchlaßverlustleistung im parallelen MOS-FET-Halbleiter auf die Art so gering wie möglich gehalten ist und ein Strom, der bei zunehmender Belastung fließt, über den in der Regel höher belastbaren IGBT geführt wird, dessen Verhalten die Durchlaßspannung konstant hält und die Differenz zum Gesamtstrom (z. B. Ids = 17 A) übernimmt.

Eine Beschränkung des Frequenzbereiches ergibt sich zweckmäßig aus einer noch vorhandenen Ausschaltverlustleistung; er ist aber wesentlich höher als z.Zt. vom IGBT-Bauteile-Hersteller angegeben. Die drei- bis fünffache Frequenz scheint erreichbar.

Die Erfindung wird im folgenden anhand von Ausführungsbeispielen erläutert, die in der Zeichnung dargestellt sind. In der Zeichnung zeigen:
- Fig. 1: ein schematisiertes Schaltbild eines Ladeaggregats mit der erfindungsgemäßen Parallelschaltung;
- Fig. 2: die Treiberschaltung für ein solches Ladeaggregat mit ihren wesentlichen Bestandteilen;
- Fig. 3: eine schematische Darstellung für das Spannungsstromverhalten und die Verlustbilanz einzelner IGBT- bzw. MOS-FET-Leistungshalbleiter im Vergleich mit der Parallelschaltung beider Transistoren.

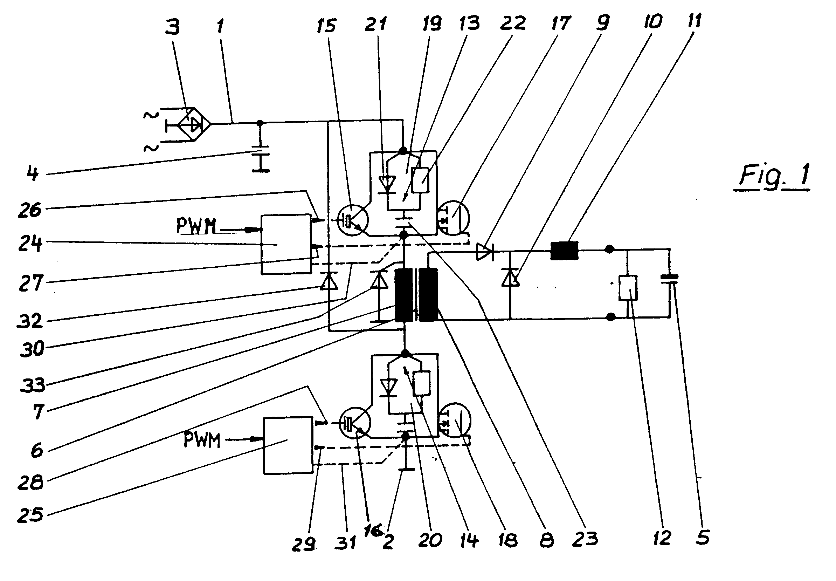

Figur 1 zeigt die schematisierte Ansicht eines Ladegeräts mit IGBT- und MOS-FET-Leistungstransistoren nach Art einer asymmetischen Halbbrücke.

Den Eingangsanschlüssen 1, 2 vom Netz her wird eine Gleichspannung zugeführt, und zwar über einen Wegegleichrichter 3, dem noch ein Glättungskondensator 4 nachgeschaltet ist. Zwischen dem Leistungseingang und dem Verbraucher, in diesem Fall eine Batterie 5, liegt eine galvanische Trennung durch einen Leistungstranformator 6 mit den beiden Wicklungen 7 - Eingangswicklung - und 8 - Ausgangswicklung - vor. An die Ausgangswicklung 8 schließen sich eine an sich bekannte Gleichrichter- und Glättungsschaltung mit Gleichrichterdiode 9, Freilaufdiode 10 und Drossel 11 an, welche den Übergangswiderstand bestimmt. Der Widerstand 12 repräsentiert den Innenwiderstand der Batterie.

Die Eingangswicklung 7 ist im vorteilhaften Ausführungsbeispiel zwischen 1 und 2 über zwei Schaltungsanordnungen 13 und 14 angeschlossen. Diese Schaltungsanordnungen bestehen aus einer unmittelbaren Parallelschaltung eines IGBT-Leistungshalbleiters 15 und 16 und eines MOS-FET-Leistungshalbleiters 17 bzw. 18. Zwischen beiden Leistungshalbleitern ist in der Parallelschaltung parallel jeweils eine Entlastungsschaltung 19, 20 angeordnet. Diese ist an sich bekannt. Sie besteht aus einer Parallelschaltung einer Diode 21 mit einem Widerstand 22 und in Reihe dazu einem Kondensator 23. Gleiches gilt für die Entlastungsschaltung 20.

Jede Parallelschaltung wird über einen Treiber 24, 25 angesteuert. Dieser Treiber hat je eine Anschlußverbindung 26, 27 zu der Steuerelektrode des IGBT-Leistungshalbleiters 15, 16 und eine weitere Anschlußverbindung 28, 29 zu der Steuerelektrode des MOS-FET-Leistungshalbleiters 17, 18.

Weiterhin wird bemerkt, daß die Schaltung noch in üblicher Weise Freilaufdioden 32, 33 aufweist, welche bei Abschaltung einen Stromdurchgang in bestimmter Weise zulassen.

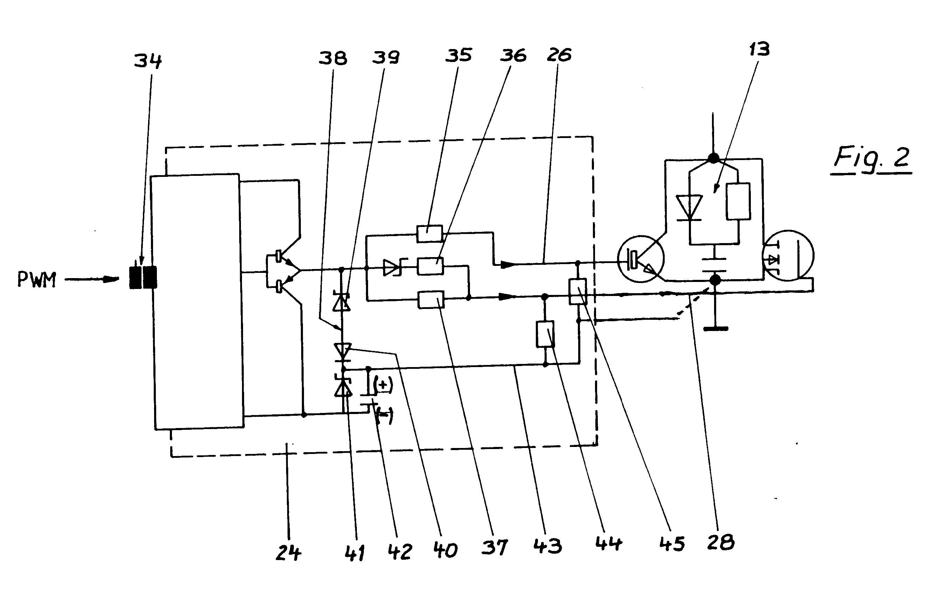

Aus Figur 2 ist beispielsweise in Verbindung mit der Schaltungsanordnung 13 erkennbar, daß der zugeordnete Treiber 24 - gleiches gilt für den Treiber 25 in Verbindung mit der Schaltungsanordnung 14 - einen galvanisch getrennten Anschluß 34 und am Ausgang eine Widerstandsschaltung aus drei Widerständen 35, 36, 37 aufweist. Hierbei ist der Widerstand 35 in der Anschlußverbindung 26 und der Widerstand 36 in der Anschlußverbindung 28 angeordnet. Die Widerstände 35, 36 sind niederohmig, während der Widerstand 37 vorgesehen ist, um einen etwas höheren Abschaltwiderstand am Anschluß 28 herbeizuführen.

Die Gate-Spannungsbegrenzung, insbesondere auch eine negative Vorspannung, wird durch die Diodenschaltung 38 mit den drei Dioden 39, 40, 41 und dem Kondensator 42 hergestellt. Hierbei sind zwischen der Leitung 43 vom Kondensator 42 bzw. einem Anschaltpunkt (Masse) zwischen den Dioden 40, 41 Beschaltungswiderstände 44 zum Anschluß 28 und 45 zum Anschluß 26 angeordnet.

Durch diese Widerstandsschaltung wird in Verbindung mit den Leistungshalbleitern, jedenfalls nur im Bereich der Einschaltelektrode vorhandenen verschiedenen Kapazitäten ein verschiedener Ausschaltzeitpunkt bestimmt, wobei insbesondere der Ausschaltzeitpunkt des MOS-FET-Halbleiters verzögert wird.

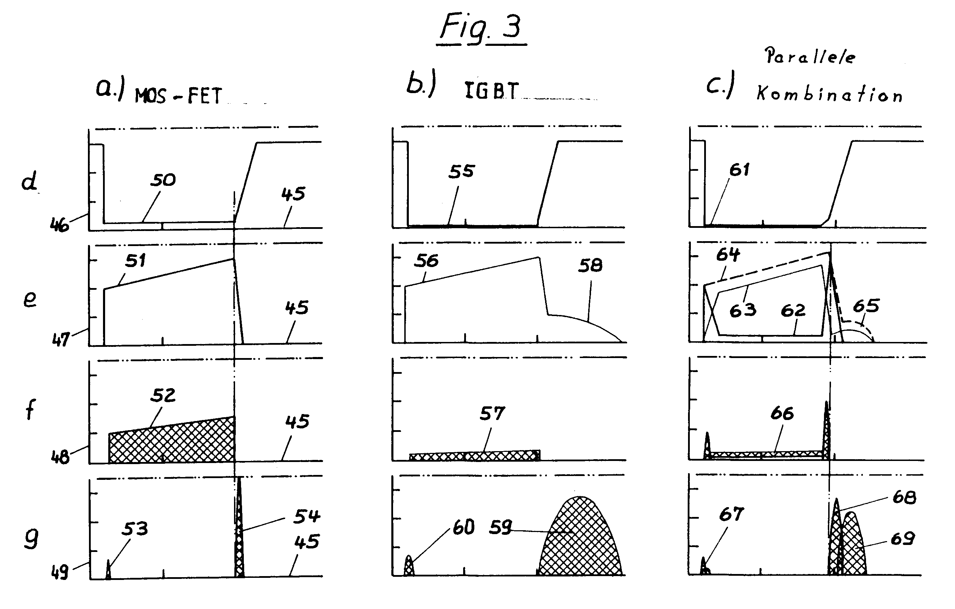

Um die Erfindung besonders zu erläutern, wird auf die Figur 3 Bezug genommen. Diese zeigt in schematisierter Darstellung drei Säulen a, b und c. Die Säule a zeigt den MOS-FET-Halbleiter, die Säule b den IGBT-Halbleiter und die Säule c die Parallelschaltung, IGBT- und MOS-FET-Halbleiter mit unterschiedlicher Ausschaltverzögerung für die Spannung und Stromkennlinien sowie die Verlustkennlinien.

Insofern sind in Figur 3 für jede Säule vier Zeilen d, e, f und g angeordnet. Die Abszisse 45 ist in jeder Darstellung die Zeitkennlinie.

In der Zeile d zeigt die Ordinate 46 jeweils die Spannung an. In Zeile e zeigt die Ordinate 47 den Strom an. In Zeile f zeigt die Ordinate 48 die Durchlaßverluste beim Stromdurchgang an. In Zeile g zeigt die Ordinate 49 die Schaltverluste an.

Der Zeitmaßstab der Abszisse ist nach ns geeicht, wobei etwa SKT = 1000 ns der Stelle entsprechen, in welcher die Säule a die Kennlinien auf ihren Tiefpunkt zeigt (SKT bezeichnet Skalenteil). Die Spannungsordinate ist in Volt geeicht, wobei die Ordinate 46 an ihrer oberen Grenze der Kennlinie links eine Spannung in der Größenordnung von 300 V zeigt.

Der in Ampere angegebene Strom in der Ordinate 47 zeigt im Durchlaßbereich von etwa 10 A bis 15 A an. In Zeile f sind die Durchlaßverluste in Watt angegeben. Hierbei liegt eine Größenordnung von 100 W bis 150 W vor.

In Zeile g sind in der Ordinate die Schaltverluste auch in Watt angegeben. Hierbei liegen obere Grenzen, die angegeben sind, in der Größenordnung von 100 W/SKT für eine sehr kurze Zeit.

Erkennbar ist in der Säule a, daß der MOS-FET-Halbleiter eine große Stromdurchlässigkeit bei hohen Durchlaßverlusten hat, aber ganz geringen Schaltverlust aufweist. Letzteres ergibt sich aus der kurzen Schaltzeit und somit aus dem steilen Spannungs- und Stromanstieg in den Zeilen d und e.

Aus der Säule b ergeben sich die für den IGBT-Halbleiter gemäß Zeile g hohen Werte für die Schaltverluste 59. Um diese Ausführung zu verdeutlichen, ist erkennbar, daß bei dem MOS-FET-Halbleiter in Säule a die Spannung nach Einschaltung auf einen Wert 50 abfällt, während in dem Bereich dieses geringen Wertes der Strom nach Zeile e entsprechend der Kennlinie 51 ansteigt. Dadurch ergeben sich auch ansteigende Durchlaßverluste 52 in Zeile f.

Der steile Anstieg bzw. Abfall der Strom- und Spannungswerte führt aber nach Zeile g zu ganz geringen Schaltverlusten entsprechend den Kurven 53 und 54. Für den IGBT-Halbleiter in Säule b zeigt sich, daß die Spannung gemäß Kurve 55 auf einen ganz geringen Wert in der Größenordnung von 3 bis 5 V fällt. Die Stromkennlinie 56 zeigt mit zunehmender Zeit an, wobei aber durch die geringe Spannung auch die geringen Durchlaßverluste 57 gemäß Zeile f erreicht werden. Wegen der Eigenart dieses Halbleiters ergibt sich aber, wie aus Zeile e hervorgeht, ein allmählicher Stromabfall gemäß Kurve 58, so daß dann am Ausgang sehr hohe Schaltungsverluste gemäß Kurve 59 in Zeile g entstehen. Auch die Einschaltverluste gemäß Kurve 60 sind gegenüber 53 etwas höher.

Die vorgesehene Parallelschaltung mit einer unterschiedlichen Ein- und Ausschaltverzögerung führt nun zu ganz besonderen Vorteilen gemäß Säule c.

Die Spannungskennlinie 61 nach Zeile d geht auf ganz geringe Werte zurück (wie IGBT 55), wobei ein allmählicher Anstieg bei Ausschaltung erfolgt. Wichtig ist aber die Stromkennlinie gemäß Zeile e. Dabei fällt an sich, weil aufgrund der Widerstandsbedingungen gemäß Säule b der Strom nach Kennlinie nach 63 im wesentlichen durch den IGBT-Halbleiter geht, der Strom im MOS-FET-Halbleiter auf die Kennlinie 62 zurück, so daß letzten Endes die verbleibende Kennlinie, die gestrichelt eingezeichnet ist, entsprechend dem Verlauf 64 entsteht. Dabei ist erkennbar, daß aufgrund der verschiedenen Stromabfälle der nachlaufende Stromabfall gemäß Kurve 58 in Säule b auf einen weitaus geringeren Wert entsprechend der Kurve 65 zurückgeht. Erkennbar ist daher aus Zeile f, daß die Durchlaßverluste 66 gegenüber 52 auf einen sehr geringen Wert und gegenüber 57 auch auf einen geringeren Wert zurückgehen.

Die Schaltverluste 67, 68, 69 entsprechend Zeile g mögen nun zwar gegenüber Säule a etwas größer sein; sie sind aber maßgeblich kleiner als gemäß Säule b, wobei diese maßgebliche Verkleinerung, bei welcher 68 dem Anteil 54 in Säule a und 69 dem Anteil 59 in Säule b entsprechen, vor allem begleitet ist durch den ganz geringen Durchlaßverlust 66. Hierin liegt das wesentliche Merkmal, wobei aus Säule c und Zeile e aus dem Verlauf der Kennlinien 62 und 63 erkennbar ist, daß die beiden Halbleiter zu verschiedenen Zeitpunkten ausgeschaltet werden, was für die beschriebene Ausgestaltung wesentlich ist.

Die verschiedenen Ausschaltungszeitpunkte ergeben sich dabei bei an sich einem Schaltungsimpuls aus den verschiedenen Vorwiderständen und den auch verschiedenen Kapazitäten in Verbindung mit der Schaltelektrode.

Im Hinblick auf obige Bemerkungen zur Einstellung der Gate/Sourcespannung am MOS-FET, derart, daß die Stromaufteilung durch die feste Durchlaßspannung a IGBT (z. B. Uds = 3,5 V) sich grundsätzlich auf einen wesentlich geringeren konstanten Wert des halben Gesamtnennstroms (z. B. von Idsg = 20 A) einstellt, wird auf eine praktische Ausführung ergänzend auf folgendes verwiesen:

Da der Einschaltwiderstand (z. B. Rdson = 1,5 Ohm) vom Typ und von der Gate/Sourcespannung abhängig ist, ist durch Auswahl und Ansteuerspannung der Durchlaßstrom sehr leicht einstellbar (z.B. Ids = 3,5 V / 1 ,5 Ohm = 2,3 A).

Ein hoher Einschaltwiderstand (Rdson) reduziert die Durchlaßstrombelastung. Die erforderliche Hochspannungsfestigkeit und die damit verbundenen hohen Rdson-Werte sind eine ideale Verbindung.

Die Durchlaß-Verlustleistung im parallelen MOS-FET-Halbleiter wird auf diese Art, so gering wie möglich gehalten. Der MOS-FET-Strom darf so groß werden, wie die Bilanz der Gesamtverlustleistung dies zuläßt. Die Grundbelastung ist damit relativ konstant.

Im Zusammenhang mit dem Ausschaltverhalten wird bemerkt, daß der MOS-FET kurzzeitig einen Pulsstrom führt, um den IGBT zu entlasten. Die Spannung steigt auf die MOS-FET-Durchlaßspannung an, anschließend um die eingestellte Zeit verzögert auf die Sperrspannung.

Der relativ hohe Spannungsabfall am MOS-FET-Leistungshalbleiter erzeugt eine kurzzeitige Pulsbelastung, die jedoch wesentlich geringer ist als die Ausschaltverluste des IGBT (Stromschwanz bei voller Sperrspannung).

Die maximale Pulsbelastung ist dem MOS-FET-Diagramm zu entnehmen.

Somit ermöglicht die Schaltung des Gerätes den Einsatz der IGBT-Bauelemente für einen wesentlich höheren Frequenzbereich mit Kostenvorteil.

Die Frequenzgrenze ist nach der Verlustbetrachtung ca. fünfmal höher und die RCD-Schutzbeschaltung kann wesentlich kleiner werden als bei nur IGBT-Einsatz.

Eine Parallelschaltung mehrerer MOS-FET-Transistoren kann sehr viel kostengünstiger durch einen parallelen IGBT-Transistor ersetzt werden, wodurch zusätzlich eine günstigere Verlustleistungsbilanz erreicht wird.

## Patentansprüche

1. Schaltgerät für höhere Frequenzen mit mindestens einer an eine Stromquelle angeschlossenen Parallelschaltung aus zwei steuerbaren Leistungshalbleitern zur Wechselrichtung einer elektrischen Größe, in Verbindung mit einem Transformator oder Motor, wobei einer der Halbleiter ein MOSFET ist und die beiden Halbleiter so angesteuert werden, daß der MOSFET gegenüber dem anderen Halbleiter zeitlich verzögert sperrt, dadurch gekennzeichnet, daß der andere Halbleiter ein IGBT (15, 16) ist, der MOSFET (17, 18) einen relativ hohen Einschaltwiderstand (Rds on) aufweist, eine einzige Treiberschaltung (24, 25) vorgesehen ist, deren Steuersignale über parallelgeschaltete Widerstände (35, 36, 37) auf die Steuerelektroden der Halbleiter (15, 16; 17, 18) gegeben werden, wobei die Sperrspannung für den MOSFET (16, 17) verzögert aufgebaut wird und der Strom durch den MOSFET (17, 18) wesentlich geringer ist als der Gesamtnennstrom durch die Parallelschaltung der Halbleiter (15, 16; 17, 18).

2. Schaltgerät nach Anspruch 1, dadurch gekennzeichnet, daß der die Steuersignale für den IGBT (15, 16) führende Widerstand (35) und der das Ausschaltsignal für den MOSFET (17, 18) führende Widerstand (37) in Abhängigkeit von den Kapazitäten der Halbleiter (15, 16; 17, 18) ausgelegt sind.

3. Schaltgerät nach Anspruch 1 oder 2, dadurch gekennzeichnet, daß die Gate-Source-Spannung am MOSFET (17, 18) so eingestellt ist, daß der Strom durch den MOSFET (17, 18) wesentlich geringer ist als die Hälfte des Gesamtnennstroms durch die Parallelschaltung der Halbleiter (15, 16; 17, 18).

## Claims

1. Switchgear for higher frequencies comprising at least one parallel connection connected to a current source and including two controllable power semiconductors for the inversion of an electrical quantity in connection with a transformer or motor, one of said semiconductors being a MOSFET and said two semiconductors being controlled so as the blocking instant of said MOSFET with respect to said other semiconductor is delayed, characterized in that said other semiconductor is an IGBT (15, 16), said MOSFET (17, 18) has a relatively high on-state resistance (Rds on), a single driver circuit (24, 25) is provided, the control signals of which are transmitted to the control electrodes of said semiconductors (15, 16; 17, 18), the generation of the blocking voltage for said MOSFET (16, 17) being delayed and the current flowing through said MOSFET (17, 8) being substantially lower than the total nominal current flowing through said parallel connection of said semiconductors (15, 16; 17, 18).

2. The switchgear according to claim 1, characterized in that said resistance (35) transmitting said control signals for said IGBT (15, 16) and said resistance (37) transmitting said switch-off signal for said MOSFET (17, 18) are rated in dependance of the capacitances of said semiconductors (15, 16; 17, 18).

3. The switchgear according to claim 1 or 2, characterized in that the gate-source-voltage of said MOSFET (17, 18) is so adjusted that the current flowing through said MOSFET (17, 18) is substantially lower than half of the total nominal current flowing through said parallel connection of said semiconductors (15, 16; 17, 18).

## Revendications

1. Dispositif de commutation haute fréquence destiné à moduler une grandeur électrique, en liaison avec un transformateur ou un moteur comportant au moins un circuit en parallèle raccordé à une source de courant et contenant deux semi-conducteurs de puissance, l'un de ces semi-conducteurs étant un semi-conducteur MOSFET et les deux semi-conducteurs étant commandés de telle façon que le semi-conducteur MOSFET se bloque avec temporisation par rapport à l'autre semi-conducteur,
caractérisé en ce que l'autre semi-conducteur est un transistor IGBT (15, 16), en ce que le MOSFET (17, 18) présente une résistance (Rds on) d'enclenchement relativement élevée, en ce qu'il est prévu un seul organe de commande (24, 25) dont les signaux de commande sont émis, par l'intermédiaire de résistances (35, 36, 37) montées en parallèle, vers les électrodes de commande des semi-conducteurs (15, 16; 17, 18), la tension de blocage pour le MOSFET (17, 18) étant temporisée et le courant traversant le MOSFET (17, 18) étant essentiellement plus faible que le courant total traversant le montage en parallèle des semi-conducteurs (15, 16; 17, 18).

2. Dispositif de commutation suivant la revendication 1, caractérisé en ce que la résistance (35) conduisant le signal de commande destiné au IGBT (15, 16) et la résistance (37) conduisant le signal de déclenchement destiné au MOSFET (17, 18) sont dimensionnées en fonction de la capacité des semi-conducteurs (15, 16; 17, 18).

3. Dispositif de commutation suivant la revendication 1 ou la revendication 2, caractérisé en ce que la tension Grille-Source sur le MOSFET (17, 18) est telle que le courant traversant le MOSFET est sensiblement inférieure à la moitié du courant nominal global traversant le montage en parallèle des semi-conducteurs (15, 16; 17, 18).
